# EUROPEAN PATENT APPLICATION

(11) **EP 1 901 174 A2**
(43) Date of publication of application: **19.03.2008**
(21) Application number: 07107400.9
(22) Date of filing: 03.05.2007
(51) Int. Cl.: G06F 13/38

(54) **Function-extended serial bus apparatus and electronic device having the same**

(30) Priority: 08.09.2006 KR 20060086813
(71) Applicant: Samsung Electronics Co., Ltd., Suwon-si, Gyeonggi-Do (KR)
(72) Inventor: Kim, Dong-hak, Banwol-dong, Taean-gu Gyeonggi-do (KR); Lee, Koang-sik, Yeongtong-dong, Yeongton-gu Suwon-si, Gyeonggi-do (KR)
(74) Representative: Grünecker, Kinkeldey, Stockmair & Schwanhäusser Anwaltssozietät

(57) **Abstract**

An electronic device includes a main body having a first component which performs a first function, a function extending unit selectively combinable to the main body having a second electronic component which performs a second function, and a serial apparatus disposed in the main body to interface between the main body and an external device and between the main body and the function extending unit. The serial apparatus includes a first terminal unit to interface between the main body and the external device, and a second terminal unit to interface between the main body and the function extending unit. The main body of the electronic device can therefore be fabricated to include only the first component

## Description

### BACKGROUND OF THE INVENTION

### 1. Field of the Invention

Aspects of the present invention relate to a serial apparatus and an electronic device having the same.

### 2. Description of the Related Art

Generally, an electronic device, such as an MP3 player, includes a serial apparatus which is connected to an external device such as, for example, a personal computer (PC), to receive electric power therefrom or to establish an interface for data communication or the like therebetween. Types of serial apparatuses include a universal serial bus (referred to as USB below), a 1394 interface, and an RS-232 interface, among other types. To describe the general structure of a serial apparatus, the structure of the USB will be explained below as a representative structure.

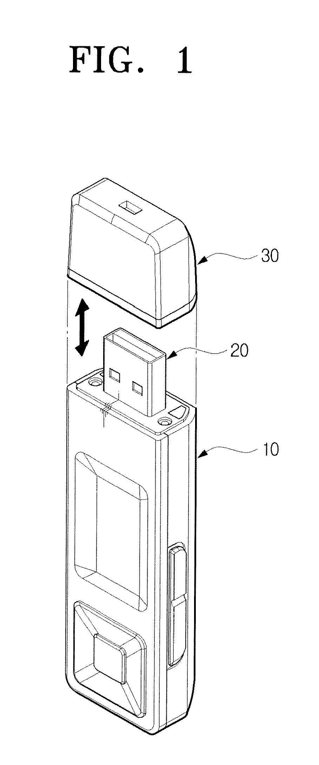

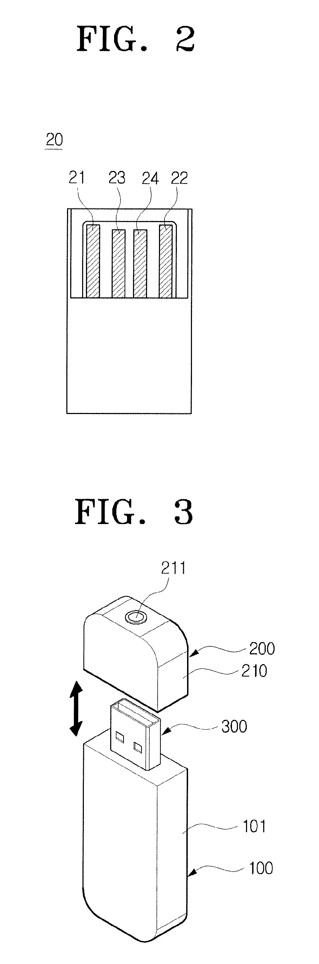

As illustrated in FIGS. 1 and 2, an electronic device having a general USB apparatus, for example, an MP3 player, includes a main body 10, a USB terminal 20 integrally formed on the main body 10, and a protecting cover 30 to protect the USB terminal 20.

The USB terminal 20 includes a VCC line 21 to receive electric power from a PC, a ground line (GND) 22, and a pair of data lines (D+, D-) 23 and 24 to communicate data between the main body 10 and the PC.

The electronic device as described above is configured so that the USB terminal 20 is integrally formed on the main body 10. Accordingly, the electronic device can directly connect with a USB port (not illustrated) and download MP3 files or the like without requiring a separate cable,

Recently, consumers have demanded more diversified products, and specifically, consumers have demanded an electronic device which has a low price and which also performs various functions, including receiving FM radio as well as recording and reproducing MP3s. Accordingly, to meet such a demand of the consumers, manufacturers have begun fabricating electronic devices which have components inside the main body 10 capable of performing a plurality of functions.

However, if the electronic device is fabricated to embody a plurality of components which perform a plurality of functions in the main body 10, problems may occur because fabrication costs are not only increased, but also it is difficult to design the electronic device in a miniature and slim size.

### SUMMARY OF THE INVENTION

Aspects of the present invention address at least the above problems and/or disadvantages and provide at least the advantages described below. Accordingly, an aspect of the present invention is to provide a serial apparatus capable of reducing fabrication costs while realizing various functions that consumers want, and designing a product in a miniature and slim size, and an electronic device having the same.

Additional aspects and/or advantages of the invention will be set forth in part in the description which follows and, in part, will be obvious from the description, or may be learned by practice of the invention.

According to an aspect of the present invention, a serial apparatus integrally formed on an electronic device includes a first terminal unit to interface between a main body of the electronic device and an external device, and a second terminal unit to interface between the main body and a function extending unit.

According to an aspect, the first terminal unit may include a VCC line to receive electric power from the external device, a ground line, and a pair of first data lines to communicate data between the main body and the external device.

According to an aspect, the second terminal unit may include a second data line to communicate data between the main body and the function extending unit, and a pair of audio lines to transmit an audio signal from the main body to the function extending unit.

According to an aspect, the second terminal unit further includes a clock line to synchronize the data passing through the second data line with a predetermined clock and to transmit the synchronized data to the function extending unit.

According to an aspect, the first and the second terminal units are respectively disposed on opposite sides inside of the serial apparatus.

According to another aspect of the present invention, an electronic device includes a main body having a first component which performs a first function, a function extending unit selectively combinable to the main body, having a second component which performs a second function, and a serial apparatus disposed in the main body to interface between the main body and an external device and between the main body and the function extending unit.

According to another aspect, the second electronic component includes a plurality of sub-components.

According to another aspect, the first component includes an MP3 player.

According to another aspect, the main body includes an MP3 codec, an audio codec, a USB block, an input terminal, an output terminal, a control unit to control the MP3 codec, the audio codec, the USB block, the input terminal and the output terminal, and a memory unit to store data.

According to another aspect, the function extending unit has a cap shape which fits over the serial apparatus to protect the serial apparatus.

According to another aspect, the second electronic component includes at least one of an FM tuner, an FM transmitter, and a laser pointer.

According to another aspect, the electronic device further includes a flexible printed circuit board (FPCB) to electrically connect the main body to the serial apparatus.

According to another aspect, the serial apparatus includes a USB terminal.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a perspective view exemplifying an electronic device having a general serial apparatus;
FIG. 2 is a schematic view exemplifying inner terminal lines of the serial apparatus shown in FIG. 1;
FIG. 3 is a perspective view exemplifying an electronic device having a serial apparatus 300 according to an embodiment of the present invention;
FIGS. 4A and 4B are perspective views exemplifying embodiments of a function extending unit 200 of the electronic device shown in FIG. 3;
FIG. 5 is a schematic view exemplifying inner terminal lines of the serial apparatus 300 shown in FIG. 3; and
FIG. 6 is a block diagram exemplifying the electronic device according to an embodiment of the present invention.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain the present invention by referring to the figures.

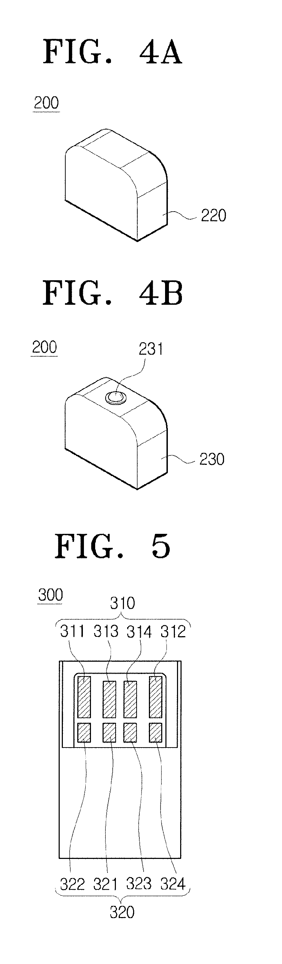

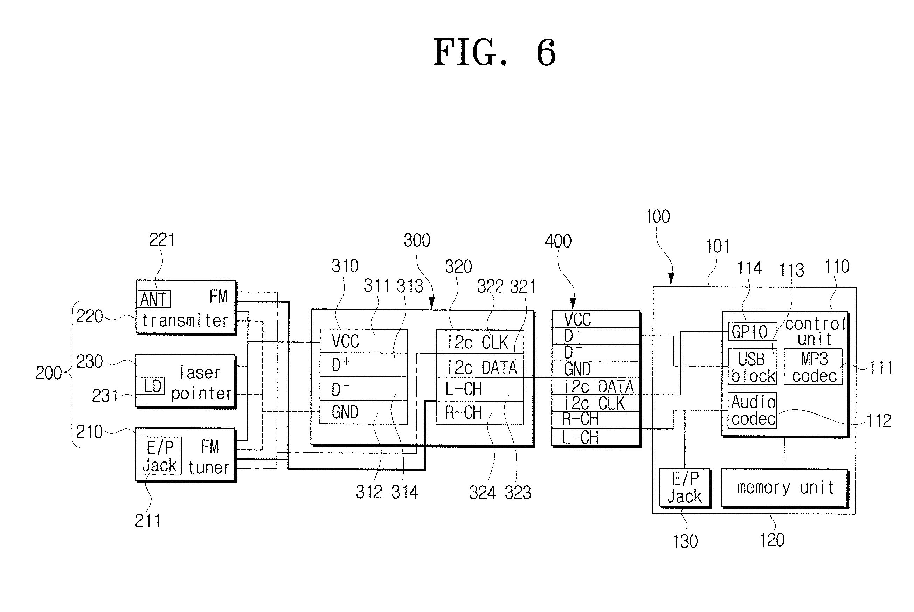

FIG. 3 is a perspective view exemplifying an electronic device having a serial apparatus according to an embodiment of the present invention, FIGS. 4A and 4B are perspective views exemplifying embodiments of a function extending unit 200 of the electronic device shown in FIG. 3, FIG. 5 is a schematic view exemplifying inner terminal lines of the serial apparatus 300 shown in FIG. 3, and FIG. 6 is a block diagram exemplifying the electronic device according to the exemplary embodiment of the present invention.

As illustrated in FIGS. 3 through 6, the electronic device according to an embodiment of the present invention includes a main body 100, a function extending unit 200, and a serial apparatus 300.

The main body 100 houses a first component which performs a first function. This first component is preferably, but not necessarily, an MP3 player 101 to record and/or reproduce a medium file, such as, for example, an MP3 file. The MP3 player 101 has a control unit 110 to control an MP3 codec 111, an audio codec 112, a USB block 113, an input and output terminal (GPI0) 114, etc., a memory unit 120 to store data, and an earphone jack (E/P Jack) 130 to listen an audio. It is understood that the MP3 player 101 may have other components instead of or in addition to the components described above.

The function extending unit 200 preferably has a cap shape to accommodate the serial apparatus 300. The function extending unit 200 has a second component which performs a second predetermined function different from the function performed by the first component housed in the main body 100. For instance, the function extending unit 200 may include an FM tuner 210 to receive FM radio waves, an FM transmitter 220 to transmit FM radio waves, and/or a laser pointer 230 to irradiate a laser beam, which are all known in the art. The FM tuner 210 includes an FM tuner integrated circuit (lC) (not illustrated) and an earphone jack 211, the FM transmitter 220 includes an FM transmitter lC (not illustrated) and an antenna (ANT) 221, and the laser pointer 230 includes a laser diode (LD) 231.

The function extending unit 200 is not limited to including only one component, and may instead include a plurality of components (also known as sub-components). Also, the function extending unit 200 is not limited to including only the FM tuner 210, the FM transmitter 220, and/or the laser pointer 230 as described above, but may instead include many other components which perform many different types of other functions. For example, the function extending unit 200 could include an AM tuner to receive AM radio waves, a small speaker, a microphone, an infra-red unit, and various other components commonly found in electronic devices today.

The serial apparatus 300 is integrally formed with the main body 100 and interfaces between the main body 100 and an external device (not illustrated), for example, a personal computer (PC), and between the main body 100 and the function extending unit 200. The serial apparatus is preferably, but not necessarily, a USB. The serial apparatus 300 is electrically connected with the main body 100 by a circuit board, which is preferably, but not necessarily, a flexible printed circuit board (FPCB) 400. The serial apparatus 300 includes a first terminal unit 310 to interface between the main body 100 and the external device, and a second terminal unit 320 to interface between the main body 100 and the function extending unit 200. It is understood that the serial apparatus 300 may have more than two terminal units.

The first terminal unit 310 includes a VCC line 311 to receive electric power from the external device, a ground line (GND) 312, and a pair of data lines (D+, D-) 313 and 314 (also known as a pair of first data lines) to communicate data between the main body 100 and the external device. The first terminal unit 310 is preferably, but not necessarily, disposed in front of the inside of the serial apparatus 300, where the front indicates the front of the electronic device. It is understood that the first terminal unit 310 may be disposed elsewhere, such as in the rear or a side of the inside of the serial apparatus 300, or on the outside of the serial apparatus 300.

The second terminal unit 320 includes a data line (i2c DATA) 321 (also known as a second data line) to communicate data between the main body 100 and the function extending unit 200, a clock line (i2c CLK) 322 to synchronize the data passing through the data line 321 with a predetermined clock and to transmit the synchronized data to the function extending unit 200, and audio lines 323 and 324 of left and right channels (L-CH, R-CH) to transmit an audio signal from the main body 100 to the function extending unit 200. The second terminal unit 320 is preferably, but not necessarily, disposed in the rear of the inside of the serial apparatus 300, for example, in the rear of the first terminal unit 310, so that lines of the first terminal unit (VCC line 311, GND 312 and data lines 313 and 314) and the second terminal unit (data line 321, clock line 322 and audio lines 323 and 324) align or alternate with each other. It is understood that the second terminal unit 320 may be disposed elsewhere, such as in the front or a side of the inside of the serial apparatus 300, or on the outside of the serial apparatus 300.

The electronic device according to an embodiment of the present invention constructed as described above connects the serial apparatus 300 formed on the main body 100 having the MP3 player 101 function to the external device, that is, connects the serial apparatus 300 to a USB port (not illustrated) of the PC, to download desired MP3 files to the main body 100 from the PC and then reproduce the MP3 files using the MP3 player 101 housed within the main body 100, thereby allowing a user to hear the MP3 files. To be more specific, electric power is supplied to the main body 100 through the VCC line 311 of the serial apparatus 300 from the PC. The control unit 110 of the main body 100 downloads the MP3 files to the USB block 113 of the main body 100 through the data lines 313 and 314 of the serial apparatus 300 from the PC, and then stores the MP3 files in the memory unit 120. The MP3 codec 111 decodes the MP3 files stored in the memory unit 120 and then transmits the decoded MP3 files to the audio codec 112. The audio codec 112 converts the transmitted MP3 files into analog signals and outputs the MP3 files converted into the analog signals to the earphone jack 130.

In the electronic device described above, the function extending unit 200 having the FM tuner 210 is connected to the serial apparatus 300 of the main body 100 after the MP3 files have been downloaded, so that the user can reproduce and listen to MP3 files using the MP3 player 101 disposed in the main body 100, or alternatively choose to listen to FM radio through the FM tuner 210 built into the function extending unit 200. To be more specific about the FM tuner 210, the FM tuner IC built into the FM tuner 210 is controlled by a control signal transmitted from the main body 100 through the second data line 321 and the clock line 322 of the serial apparatus 300, enabling the user to listen to FM radio through the earphone jack 211 formed in the FM tuner 210. Also, the main body 100 preferably includes a controller (not shown) which a user uses to transmit the control signal to the electronic device and the function extending unit 200. When the function extending unit 200 is connected to the main body 100, the controller may be used to switch operations between the function extending unit 200 and the electronic device. This controller may be any kind of controller known in the art, and a detailed description thereof will be omitted.

In another embodiment, the electronic device includes the function extending unit 200 having the FM transmitter 220 connected to the serial apparatus 300 of the main body 100, so that the user can reproduce and listen to MP3 files using the MP3 player 101 disposed in the main body 100, and transmit the MP3 files by FM radio to a car audio unit (not illustrated) and the like through the FM transmitter 220 built into the function extending unit 200. To be more specific about the FM transmitter 220, the FM transmitter lC built into the FM transmitter 220 is controlled by a control signal transmitted from the main body 100 through the second data line 321 and the clock line 322 of the serial apparatus 300, enabling the MP3 files transmitted from the main body 100 to be transmitted by FM radio waves to the car audio unit and the like through an FM frequency of the antenna 221 transmitted by the FM transmitter 220, thereby allowing the user to listen to the MP3 files through the car audio unit or the like.

In still another embodiment, the electronic device includes the function extending unit 200 having the laser pointer 230 connected to the serial apparatus 300 of the main body 100, so that the user can reproduce and listen to MP3 files using the MP3 player 101 disposed in the main body 100, and also use the electronic device as a pointing apparatus by activating the laser pointer 230 built into the function extending unit 200. To be more specific about the laser pointer 230, electric power is supplied from the main body 100 through the VCC line 311 of the serial apparatus 300, enabling the laser diode built into the laser pointer 230 to emit a laser beam and carry out the pointer function.

The electronic device according to an embodiment of the present invention has a single function, specifically, recording and reproducing MP3 files using the MP3 player 101. The function extending unit 200 having the predetermined components and functions which are different from that of the MP3 player housed in the main body 100, that is, the FM tuner 210, the FM transmitter 220, and/or the laser pointer 230, is separately fabricated and then connected to the function-extended serial apparatus 300 formed on the main body 100. Accordingly, fabrication costs of the main body 100 are reduced, and consumers can select a function extending unit 200 having only the additional components needed to perform desired functions, thus allowing users to inexpensively purchase the electronic device.

In addition, the main body 100 of the electronic device is fabricated to encase a basic component, such as an MP3 player, so that the electronic device can be designed in a slim and miniature size. Also, the electronic device does not require a separate connector to connect the main body 100 and the function extending unit 200, because the serial apparatus 300, which connects the main body 100 to a PC, also connects the main body 100 to the function extending unit 200. Thus, fabrication costs are additionally reduced because the function extending unit 200 does not require a separate cable to connect with the main body 100.

As is apparent from the foregoing description, according to embodiments of the present invention, the serial apparatus and the electronic device having the same are fabricated so that only a single component is embodied in the main body 100. Accordingly, the fabrication costs of the electronic device are not only reduced, but the size of the electronic device is also reduced to a very slim and miniature size.

In addition, consumers can select function extending units 200 having only desired additional components. Thus, users can inexpensively purchase the electronic device, and then choose between desired additional components by purchasing function extending units 200 having the desired components.

Also, the serial apparatus and the electronic device having the same according to embodiments of the present invention do not require a separate connector to connect the main body 100 and the function extending unit 200, because the serial apparatus 300, which is used to connect between the main body to the PC, is also used to connect the main body 100 to the function extending unit 200. Thus, fabrication costs are additionally reduced.

Although a few embodiments of the present invention have been shown and described, it would be appreciated by those skilled in the art that changes may be made in this embodiment without departing from the principles and spirit of the invention, the scope of which is defined in the claims and their equivalents.

## Claims

1. A serial apparatus integrally formed on an electronic device comprising:
a first terminal unit to interface between a main body of the electronic device and an external device; and
a second terminal unit to interface between the main body and a function extending unit.

2. The serial apparatus as claimed in claim 1, wherein the first terminal unit comprises:
a VCC line to receive electric power from the external device;
a ground line; and
a pair of first data lines to communicate data between the main body and the external device.

3. The serial apparatus as claimed in claim 2, wherein the second terminal unit comprises:
a second data line to communicate data between the main body and the function extending unit; and
a pair of audio lines to transmit an audio signal from the main body to the function extending unit.

4. The serial apparatus as claimed in claim 3, wherein the second terminal unit further comprises a clock line to synchronize the data passing through the second data line with a predetermined clock and to transmit the synchronized data to the function extending unit.

5. The serial apparatus as claimed in claim 1, wherein the first terminal unit and the second terminal unit are respectively disposed on opposite sides inside of the serial apparatus.

6. The serial apparatus as claimed in claim 4, wherein the VCC line, the pair of first data lines and the ground line are respectively disposed across from the clock line, the second data line, and the pair of audio lines inside the serial apparatus.

7. The serial apparatus as claimed in claim 4, wherein the VCC line, the pair of first data lines and the ground line are respectively disposed to alternate between the clock line, the second data line, the pair of audio lines, and a side of the serial apparatus.

8. The serial apparatus as claimed in claim 3, wherein the second data line comprises an i2c data line.

9. The serial apparatus as claimed in claim 4, wherein the clock line comprises an i2c clock line.

10. The serial apparatus as claimed in claim 1, wherein the serial apparatus comprises a USB terminal.

11. An electronic device comprising:
a main body having a first component which performs a first function;
a function extending unit selectively combinable to the main body, having a second component which performs a second function; and
a serial apparatus disposed in the main body to interface between the main body and an external device and between the main body and the function extending unit.

12. The device as claimed in claim 11, wherein the second component comprises a plurality of sub-components.

13. The device as claimed in claim 11, wherein the first component comprises an MP3 player.

14. The device as claimed in claim 13, wherein the main body comprises:
an MP3 codec;
an audio codec;
a USB block;
an input terminal;
an output terminal;
a control unit to control the MP3 codec, the audio codec, the USB block, the input terminal and the output terminal; and
a memory unit to store data.

15. The device as claimed in claim 14, wherein the data stored in the memory unit comprises MP3 files.

16. The device as claimed in claim 11, wherein the function extending unit has a cap shape which fits over the serial apparatus to protect the serial apparatus.

17. The device as claimed in claim 11, wherein the second component comprises at least one of an FM tuner, an FM transmitter, and a laser pointer.

18. The device as claimed in claim 11, wherein the serial apparatus comprises:
a first terminal unit to interface between the main body and the external device; and
a second terminal unit to interface between the main body and the function extending unit.

19. The device as claimed in claim 18, wherein the first terminal unit comprises:
a VCC line to receive electric power from the external device;
a ground line; and
a pair of first data lines to communicate data between the main body and the external device.

20. The device as claimed in claim 19, wherein the second terminal unit comprises:
a second data line to communicate data between the main body and the function extending unit; and
a pair of audio lines to transmit an audio signal from the main body to the function extending unit.

21. The device as claimed in claim 20, wherein the second terminal unit further comprises a clock line to synchronize the data passing through the second data line with a predetermined clock and to transmit the synchronized data to the function extending unit.

22. The device as claimed in claim 18, wherein the first terminal unit and the second terminal unit are respectively disposed on opposite sides inside of the serial apparatus.

23. The device as claimed in claim 11, further comprising:
a flexible printed circuit board (FPCB) to electrically connect the main body to the serial apparatus.

24. The device as claimed in claim 11, wherein the serial apparatus comprises a USB terminal.

25. The device as claimed in claim 21, wherein the VCC line, the pair of first data lines and the ground line are respectively disposed across from the clock line, the second data line, and the pair of audio lines inside the serial apparatus.

26. The device as claimed in claim 21, wherein the VCC line, the pair of first data lines and the ground line are respectively disposed to alternate between the clock line, the second data line, the pair of audio lines, and a side of the serial apparatus.

27. The device as claimed in claim 20, wherein the second data line comprises an i2c data line.

28. The device as claimed in claim 21, wherein the clock line comprises an i2c clock line.

29. A function extending unit which fits on a serial apparatus connected to an electronic device, comprising:
an outer case which receives and electrically connects the serial apparatus to electrically connect the function extending unit to the electronic device; and
an electrical component which performs an electrical function and electrically communicates with the electronic device when the outer case electrically connects the function extending unit to the electronic device.

30. The function extending unit as claimed in claim 29, wherein the function extending unit is detachable from the electronic device.

31. The function extending unit as claimed in claim 29, wherein the electrical component comprises an FM tuner.

32. The function extending unit as claimed in claim 29, wherein the electrical component comprises an FM transmitter.

33. The function extending unit as claimed in claim 29, wherein the electrical component comprises a laser pointer having a laser diode to emit a laser beam outside of the outer case.

34. The function extending unit as claimed in claim 29, wherein the function extending unit is shaped like a cap to receive a USB terminal.
